(19) Europäisches Patentamt / European Patent Office / Office européen des brevets

(11) **EP 2 540 437 B1**

(12) **FASCICULE DE BREVET EUROPEEN**

(45) Date de publication et mention de la délivrance du brevet:
**25.04.2018 Bulletin 2018/17**

(51) Int Cl.:
**B23K 35/36** *(2006.01)*    **B23K 35/02** *(2006.01)*
**B23K 35/30** *(2006.01)*

(21) Numéro de dépôt: **12174012.0**

(22) Date de dépôt: **28.06.2012**

(54) **PROCEDE DE FABRICATION D'UN DISPOSITIF COMPRENANT DES BRASURES REALISEES A PARTIR D'OXALATE METALLIQUE**

HERSTELLUNGSVERFAHREN EINER VORRICHTUNG, DIE MIT METALLOXALAT AUSGEFÜHRTE LÖTUNGEN UMFASST

METHOD FOR MANUFACTURING A DEVICE COMPRISING BRAZED JOINTS MADE FROM METAL OXALATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.06.2011 FR 1102036**

(43) Date de publication de la demande:
**02.01.2013 Bulletin 2013/01**

(73) Titulaires:
- **Thales**
  **92400 Courbevoie (FR)**
- **Université Paul Sabatier (Toulouse III)**
  **31062 Toulouse Cedex 9 (FR)**
- **Centre National de la Recherche Scientifique**
  **75016 Paris (FR)**

(72) Inventeurs:
- **VENDIER, Olivier**
  **31120 LACROIX-FALGARDE (FR)**
- **RAYNAUD, Lidwine**
  **81370 SAINT-SULPICE (FR)**
- **BACO, Valérie**
  **31860 LABARTHE SUR LEZE (FR)**
- **GOUGEON, Michel**
  **31400 TOULOUSE (FR)**
- **LE TRONG, Hoa**
  **756000 HO CHI MINH (VN)**
- **TAILHADES, Philippe**
  **31650 SAINT-ORENS (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
| | |
|---|---|
| **EP-A- 0 254 935** | **GB-A- 294 880** |
| **US-A- 4 662 952** | **US-A1- 2003 148 024** |
| **US-A1- 2005 142 839** | |

- **DATABASE WPI Week 199232 Thomson Scientific, London, GB; AN 1992-266554 XP002669674, & SU 1 687 407 A1 (AS USSR COSMIC RES INSTCONSTR BUR) 30 octobre 1991 (1991-10-30)**
- **DATABASE WPI Week 197434 Thomson Scientific, London, GB; AN 1974-60556V XP002669675, & JP 49 017353 A (SENJU METAL IND CO) 15 février 1974 (1974-02-15)**
- **Sam Barros: "Powerlabs Oxalate Explosive Synthesis", Internet , 1 décembre 2003 (2003-12-01), XP002669676, Extrait de l'Internet: URL:http://www.powerlabs.org/chemlabs/silver_oxalate.htm [extrait le 2012-02-14]**

**Description**

Le domaine de l'invention est celui des interfaces métalliques de type brasure pour composants de puissance pouvant notamment être à base de GaAs, GaN ou SiC, et pouvant par exemple être embarqués à bord de satellites et donc potentiellement soumis à de fortes températures et de fortes pressions.

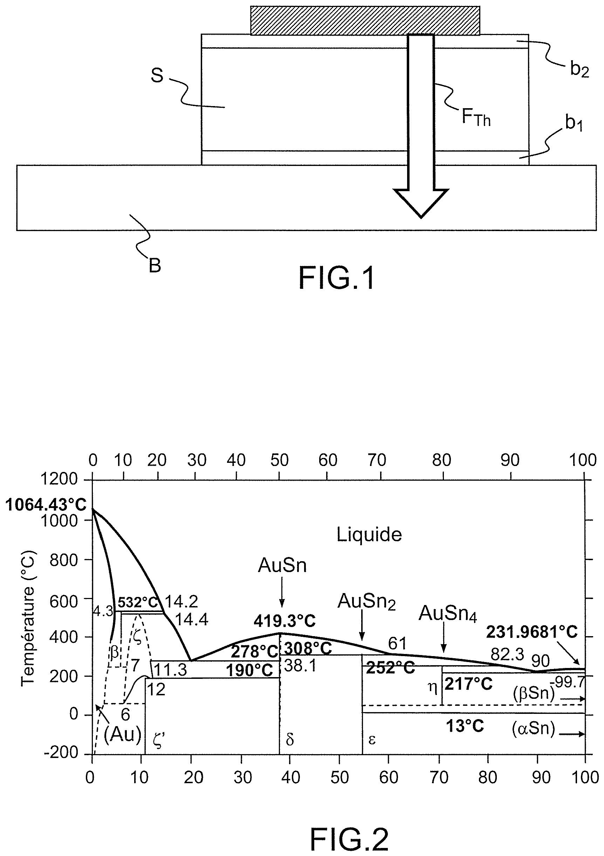

La figure 1 illustre un exemple de composant de puissance comportant un fond de boîtier B, deux brasures $b_1$ et $b_2$ de part et d'autre d'un support S permettant l'évacuation de l'énergie thermique produite par le composant électronique, la brasure $b_2$ étant en contact avec le composant de puissance $C_{omp}$, des finitions d'or étant nécessaires assurant des contacts électriques et thermiques de qualité et stables d'un point de vue chimique, la flèche $F_{Th}$ indiquant la direction du flux thermique généré lors du fonctionnement du composant $C_{omp}$.

Certains procédés de brasage mettent en oeuvre des alliages à bas point de fusion. Ces alliages présentent toutefois différents inconvénients :

- des propriétés mécaniques médiocres liées à la formation d'intermétalliques et à un recouvrement inhomogène des surfaces à assembler (cas des brasures base Au-Sn) ;

- une mauvaise tenue en température (cas des brasures Ag-Sn, Cu-Sn et AuSn), si on suppose que les températures de socle vont avoir tendance à augmenter avec les composants de type GaN ;

- une trop grande réactivité avec les couches de finitions comprenant notamment de l'or disposées à la surface des pièces à assembler (cas de In-Sn).

Par ailleurs, les brasures actuelles à base d'or ou d'argent qui pourraient présenter une très bonne conductivité thermique et des propriétés mécaniques intéressantes, sont difficiles à mettre en oeuvre compte tenu de leur point de fusion comme le montre la figure 2 qui fournit les points de fusion de certains eutectiques à base d'or, montrant que ces derniers sont très élevés, générant par la même une mise en oeuvre difficile.

En parallèle, il a déjà été proposé des encres et/ou pâtes nanométriques à base d'argent commercialisées, présentant des bas points de fusion, typiquement inférieurs à 300°C, pour notamment la réalisation de conducteurs sur substrats plastiques. Ces encres et/ou pâtes ne sont néanmoins pas compatibles avec les composants de puissance notamment adressés dans la présente invention, car présentant des porosités importantes et donc de mauvaises résistances aux fortes pressions.

Les brasures avec des oxalates métalliques sont connues, voir par exemple le document GB294880. Le document EP0254935 décrit un procédé d'obtention d'un oxalate d'argent par précipitation dans un milieu aqueux.

Dans ce contexte, la présente invention a pour objet un procédé original pour réaliser des brasures compatibles avec des dépôts d'or et assurant à la fois une très bonne conductivité thermique en même temps qu'une très bonne résistance aux fortes pressions.

L'idée de base de la présente invention consiste à apporter le métal de brasage via un oxalate métallique dont la température de décomposition est basse. Lors de sa décomposition thermique, l'oxalate génère des clusters ou particules nanométriques métalliques dont la température de fusion est plus basse que celle du métal à l'état massif. Ces particules qui présentent par ailleurs un très grand rapport surface / volume, ont en conséquence une grande propension au frittage. Cette caractéristique est favorable à l'opération de brasage et reste compatible avec des moyens de production « dispensing/pick&place » correspondant à une enduction localisée.

Dans le cas de l'oxalate d'argent ou d'un mélange d'oxalates d'argent et de cuivre, la décomposition est fortement exothermique. L'apport local d'énergie permet une élévation de température au-delà de la température de brasage appliquée à l'ensemble des pièces à assembler. L'apport d'énergie étant local et de très courte durée il contribue à faciliter le frittage voire la fusion du métal généré, sans pour autant dégrader les composants électroniques à braser.

La maîtrise de la taille et de la forme des particules d'oxalate ainsi que la qualité de la dispersion de ces dernières dans la pâte à braser, contribue en outre à former des brasures homogènes et exemptes de fissuration.

Plus précisément, la présente invention a pour objet un procédé de fabrication d'un dispositif comprenant au moins un support et un composant, reliés entre eux par au moins une brasure caractérisé en ce que l'opération de brasure est réalisée à partir d'un oxalate métallique. L'oxalate métallique est obtenu par précipitation chimique d'un sel soluble métallique, l'acide oxalique ou l'oxalate d'ammonium, dissous dans des solvants hydro-alcooliques possédant de préférence des constantes diélectriques comprises entre 17 et 80.

Des particules de faible taille peuvent être obtenues préférentiellement lorsque ces solvants ont de faibles constantes diélectriques et que les concentrations des deux solutions sont fortes voire proches de la saturation. Selon une variante de l'invention, l'oxalate est un oxalate d'argent ou un mélange d'oxalates d'argent et de cuivre.

Selon une variante de l'invention, le composant et/ou le support comprennent en surface un film comprenant de l'or ou du cuivre sur lequel est réalisée ladite brasure.

Selon une variante de l'invention, la brasure est réalisée à partir d'une suspension contenant de l'oxalate métallique.

Selon une variante de l'invention, la brasure est réalisée à partir d'une pâte contenant de l'oxalate métallique.

Il est à noter que la suspension est caractérisée par une teneur en oxalate plus faible et une viscosité plus faible que la pâte et est préférentiellement utilisée pour réaliser des brasures de faible épaisseur.

Selon une variante de l'invention, l'opération de brasure comprend en outre les étapes suivantes :

- l'élaboration d'une suspension ou d'une pâte, à braser contenant de l'oxalate métallique ;
- le dépôt de ladite suspension ou de ladite pâte à la surface dudit support et/ou dudit composant ;
- l'assemblage du support et du composant via ladite suspension ou ladite pâte;
- le chauffage de l'ensemble préconstitué.

Selon une variante de l'invention, l'élaboration de ladite suspension ou de ladite pâte comprend les étapes suivantes :

- la précipitation chimique en milieu aqueux ou hydro-alcoolique d'un sel soluble métallique par de l'acide oxalique ou un oxalate soluble ;
- l'obtention d'un précipité d'oxalate présentant des caractéristiques granulométriques et morphologiques maîtrisées conduisant à des tailles de particules supérieures à environ 40 nm pour le mélange d'oxalate comprenant du cuivre et de l'argent et environ 0,1 microns pour l' oxalate d'argent,
- le lavage du précipité formé ;
- la mise en suspension de l'oxalate dans un milieu aqueux ou hydro-alcoolique à une concentration choisie pour obtenir une suspension ou une pâte, de viscosité contrôlée.

Selon une variante de l'invention, le dépôt de la suspension à base d'oxalate est réalisé par pulvérisation.

Selon une variante de l'invention, le dépôt de la suspension à base d'oxalate est réalisé par jet d'encre.

Selon une variante de l'invention, le dépôt de la pâte à base d'oxalate est réalisé par enduction.

Selon une variante de l'invention, le dépôt de la pâte à base d'oxalate est réalisé par sérigraphie.

Selon une variante de l'invention, le procédé comprend une étape de séchage du dépôt de ladite suspension ou de ladite pâte avant l'assemblage du support et du composant via ladite suspension ou ladite pâte à base d'oxalate métallique.

Selon une variante de l'invention, l'étape de séchage est effectuée à une température de l'ordre de 100°C sous air ou sous vide primaire ou par un procédé de lyophilisation.

Selon une variante de l'invention, le chauffage de l'ensemble est effectué à une température de l'ordre 200°C.

Selon une variante de l'invention, le chauffage de l'ensemble est effectué à une vitesse de chauffe supérieure à environ 150°C/h.

Selon une variante de l'invention, le composant est un composant de puissance, pouvant notamment être à base GaAs, GaN ou SiC.

L'invention sera mieux comprise et d'autres avantages apparaîtront à la lecture de la description qui va suivre donnée à titre non limitatif et grâce aux figures annexées parmi lesquelles :

- la figure 1 illustre un exemple de composant de puissance relié via des brasures à un fond de boîtier ;
- la figure 2 illustre les points de fusion de différents eutectiques à base d'or ;
- la figure 3 illustre la courbe de décomposition de l'oxalate d'argent en fonction de la température ;
- la figure 4 illustre la puissance dissipée en fonction de la température dans le cas d'une brasure classique et dans le cas d'une brasure réalisée selon l'invention.

Le procédé de la présente invention comprend la réalisation de brasure à base d'oxalate métallique, il peut avantageusement s'agir d'oxalate d'argent $Ag_2C_2O_4$ ou d'un mélange d'oxalates d'argent $Ag_2C_2O_4$ et de cuivre $CuC_2O_4$, pour fabriquer un dispositif comprenant notamment un composant à assembler sur un support, pouvant être par exemple le fond de boîtier illustré en figure 1.

Nous allons décrire ci-après les différentes étapes d'un exemple de procédé selon l'invention.

Première étape : élaboration de la suspension ou de la pâte à braser

On réalise la précipitation chimique dans des conditions contrôlées en milieu aqueux ou hydro-alcoolique d'un sel soluble d'argent ou de cuivre par de l'acide oxalique ou un oxalate soluble.

Pour cela on peut procéder selon les exemples décrits ci-après :

Exemple 1 : (Référence)

On procède à l'élaboration d'oxalate d'argent par précipitation par l'acide oxalique dans l'eau (poudre P1) à partir d'une solution A de 25,480g de nitrate d'argent $AgNO_3$ dissous dans 150 ml l'eau distillée et d'une solution B de 47,276g d'acide oxalique $H_2C_2O_4.2H_2O$ dissous dans 750 ml d'eau distillée agitée par une pale tournant à 250 tours/min.

La solution saline A est introduite dans la solution oxalique à une vitesse contrôlée à l'aide de pompes péristaltiques (v = 30 ml/min). Les points d'addition de la solution saline sont dispersés à la surface de la solution oxalique.

Quand toute la solution d'argent a été ajoutée, l'agitation est maintenue pendant 30 minutes.

On procède ensuite à des opérations de lavages :

La suspension obtenue au terme de la précipitation est ensuite centrifugée afin de séparer le précipité des eaux-mère :

- le précipité récupéré est remis en suspension dans l'eau distillée pendant 30 min, lavé à l'eau distillée pour éliminer les ions nitrate. Le lavage est répété au moins 4 fois ;
- pour le dernier lavage, l'eau est remplacée, par de l'éthanol à 95 % ;
- le précipité obtenu au terme d'une dernière centrifugation est séché dans une étuve à 60°C pendant 48h. Après désagrégation on obtient la poudre d'oxalate P1.

Les particules d'oxalate d'argent obtenues par ce procédé ont la forme de bâtonnets de 5 à 10 $\mu$m de longueur et de 2 à 5 $\mu$m de diamètre.

L'oxalate d'argent préparé est de préférence stocké à l'abri de la lumière pour prévenir sa transformation.

Exemple 2 :

L'oxalate d'argent est préparé selon un protocole analogue à celui présenté dans l'exemple 1, mais l'eau de la solution A est remplacée par 150 ml d'Ethylène glycol.

De même dans la solution B, 750 ml Butanol sont utilisés à la place de l'eau distillée pour dissoudre 47,276g d'acide oxalique $H_2C_2O_4.2H_2O$.

Le précipité est récupéré selon un protocole identique à celui décrit à l'exemple 1.

Les particules d'oxalate d'argent (poudre P2) ainsi préparées ont une taille voisine de 0,5 à 1 micron. Leur stockage est aussi effectué à l'abri de la lumière.

Exemple 3 :

On procède à l'élaboration d'oxalate de cuivre par précipitation par l'acide oxalique (poudre P3) à partir d'une solution A de 24,16g de nitrate de cuivre $Cu(NO_3)_2$, $3H_2O$ dissous dans un mélange constitué de 5 ml d'eau et de 25 ml d'éthanol et d'une solution B de 13,48g d'acide oxalique $H_2C_2O_4,-2H_2O$ dissous dans 200 ml de pentanol par une pale tournant à 250 tours/min.

La solution saline A est introduite dans la solution oxalique à une vitesse contrôlée à l'aide de pompes péristaltiques (v = 60 ml/min). Les points d'addition de la solution saline sont dispersés à la surface de la solution oxalique.

Quand toute la solution de cuivre a été ajoutée, l'agitation est maintenue pendant 20 minutes.

On procède ensuite à des opérations de lavage :

La suspension obtenue au terme de la précipitation est ensuite centrifugée afin de séparer le précipité des eaux mères. Le précipité récupéré est remis en suspension dans l'eau distillée pendant 30 minutes, lavé à l'eau distillée pour éliminer les ions nitrate. Le lavage est répété uniquement 2 fois car la suspension obtenue au terme du deuxième lavage reste stable. La poudre P3 peut être conservée en suspension dans l'eau ou être extraite de la suspension puis séchée à 80°C durant plusieurs heures.

Les particules d'oxalate de cuivre qui constituent la poudre P3 ont la forme de grains de riz de taille inférieure à 50 nm.

On obtient ainsi des précipités d'oxalate d'argent ou de cuivre présentant des caractéristiques granulométriques et morphologiques maîtrisées. L'ajout progressif de la solution A à la solution B contribue à l'obtention d'une granulométrie assez resserrée et la mise en oeuvre de solvants de constantes diélectriques plus faibles que celle de l'eau contribuent à la formation de particules de tailles submicroniques. Des concentrations élevées pour les solutions A et B sont aussi favorables à l'obtention de petites particules.

On réalise alors la mise en suspension de l'oxalate dans un milieu aqueux ou hydro-alcoolique (par exemple dans de l'éthylène glycol et de l'eau) à une concentration choisie, pour obtenir une suspension ou une pâte.

A l'aide d'un mortier en agathe, une masse de 5 g de poudre P1, dont l'élaboration a été décrite à l'exemple 1, (exemple de référence), est mélangée à 5 g d'éthylène glycol. On obtient alors une pâte S1 qui peut être utilisée en vue de la réalisation de brasures d'argent selon le protocole décrit plus loin.

Une pâte S2 peut être également préparée selon le même protocole que précédemment en utilisant la poudre P2.

A l'aide d'un mortier en agathe, une masse de 5 g de poudre P2, dont l'élaboration a été décrite à l'exemple 2, est mélangée à 25 g d'éthylène glycol. On obtient alors une suspension S3 qui peut être utilisée en vue de la réalisation de brasures d'argent selon le protocole décrit plus loin.

A l'aide d'un mortier en agate, une masse de 15 g de poudre P2 et de 5 g de poudre P3, dont l'élaboration a été décrite aux exemples 2 et 3, est mélangée à 40 g d'éthylène glycol. On obtient alors une suspension S4 qui peut être utilisée en vue de la réalisation de brasures argent-cuivre selon le protocole décrit plus loin.

A l'aide d'un mortier en agate, une masse de 13,4 g de poudre P2 et de 6,6 g de poudre P3, dont l'élaboration a été décrite aux exemples 2 et 3, est mélangée à 40 g d'éthylène glycol. On obtient alors une suspension S5 qui peut être utilisée en vue de la réalisation de brasures argent-cuivre selon le protocole décrit plus loin.

Deuxième étape : mise en oeuvre de la suspension ou de la pâte :

On procède au dépôt de la suspension par exemple par pulvérisation, méthode jet d'encre, application au pinceau,... ou de la pâte par exemple par enduction, ou sérigraphie, à braser, sur le composant ou son support.

On sèche alors sous air ou sous vide primaire à une température inférieure à 100°C.

Puis on met en contact l'ensemble : composant/suspension ou pâte à braser/support de l'élément recouvert d'oxalate avec la deuxième pièce pour réaliser l'assemblage.

On peut également enduire les faces à la fois du composant et du support pour mettre en contact deux couches à base d'oxalate.

Troisième étape : réalisation de la brasure :

On effectue enfin par un chauffage rapide, typiquement à une vitesse de chauffe supérieure à environ 150°C/h et ce jusqu'à une température supérieure à 200°C, la réalisation de la brasure. Au cours de cette étape une légère pression peut être appliquée sur les pièces à assembler, pour faciliter la densification de la brasure en cours de formation. Quatre exemples 3, 4, 5 et 6 de réalisation d'une brasure sont donnés ci-après :

Exemple 3

Une épaisseur d'environ 200 $\mu$m de pâte (S2) est déposée sur un substrat doré de 4 mm x 4 mm, La pâte est ensuite séchée sous vide primaire à la température ambiante pendant 2h. Après séchage, le substrat est recouvert par une deuxième pièce dorée pour réaliser l'assemblage.

Une faible charge disposée sur la deuxième pièce permet d'appliquer une pression de 3000 g/cm$^2$. L'ensemble est placé dans un four où on effectue un chauffage à 150°C/h jusqu'à 300°C pour réaliser la brasure. L'épaisseur de la couche d'argent métallique obtenue entre les deux pièces est de l'ordre de 100 $\mu$m.

L'application d'une force de cisaillement supérieure à 40 N est alors nécessaire pour séparer les pièces assemblées par la brasure.

Exemple 4

Une épaisseur d'environ 200 $\mu$m de pâte (S2) est déposée sur un substrat en cuivre très propre de 4 mm x 4 mm. La pâte est ensuite séchée sous vide primaire à la température ambiante pendant 2h. Après séchage, le substrat est recouvert par une deuxième pièce en cuivre fraîchement nettoyée pour réaliser l'assemblage.

Une faible charge disposée sur la deuxième pièce permet d'appliquer une pression de 3000 g/cm$^2$. L'ensemble est placé dans un four sous atmosphère neutre (N$_2$ ou Ar) purgée de l'oxygène pour éviter une oxydation du support en cuivre dans lequel, on effectue un chauffage à 150°C/h jusqu'à 300°C pour réaliser la brasure. L'épaisseur de la couche d'argent métallique obtenue entre les deux pièces est de l'ordre de 100 $\mu$m.

Exemple 5

Une épaisseur d'environ 200 $\mu$m de suspension (S4) est déposée sur un substrat doré de 4 mm x 4 mm. La suspension est ensuite séchée sous vide primaire à la température ambiante pendant 2h. Après séchage, le substrat est recouvert par une deuxième pièce dorée pour réaliser l'assemblage.

Une faible charge disposée sur la deuxième pièce permet d'appliquer une pression de 3000 g/cm². L'ensemble est placé dans un four où on effectue un chauffage à 150°C/h jusqu'à 300°C pour réaliser la brasure. L'épaisseur de la couche d'argent et de cuivre métallique obtenue entre les deux pièces est de l'ordre de 100 µm.

Exemple 6

Une épaisseur d'environ 200 µm de suspension (S5) est déposée sur un substrat doré de 4 mm x 4 mm. La suspension est ensuite séchée sous vide primaire à la température ambiante pendant 2h. Après séchage, le substrat est recouvert par une deuxième pièce dorée pour réaliser l'assemblage.

Une faible charge disposée sur la deuxième pièce permet d'appliquer une pression de 3000 g/cm². L'ensemble est placé dans un four dans lequel on effectue un chauffage à 150°C/h jusqu'à 300°C pour réaliser la brasure.

L'épaisseur de la couche d'argent et de cuivre métallique obtenue entre les deux pièces est de l'ordre de 100 µm.

Les avantages techniques du matériau de brasage proposé sont liés à sa capacité à réaliser dès 200°C une liaison à forte conductivité thermique entre des composants électroniques et leur support. Ce matériau offre la seule possibilité actuelle de braser correctement des composants électroniques de puissance fortement dissipatifs, destinés à des applications spatiales. Il peut cependant trouver d'autres applications dans le domaine de la microélectronique. Les spécificités et les performances du matériau proposé résultent de :

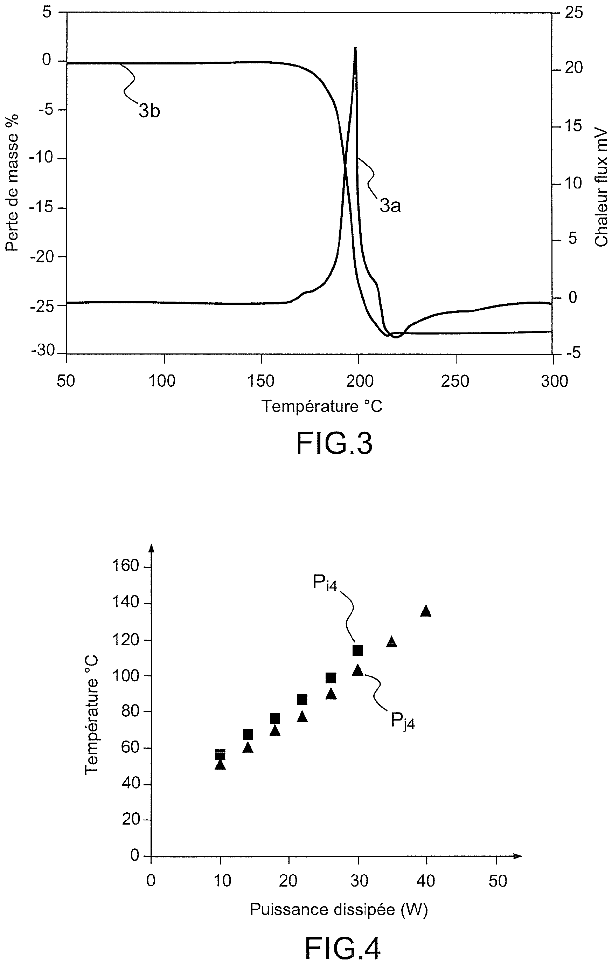

- l'apport thermique local dû à la décomposition de l'oxalate d'argent (facilitation du frittage), comme le montre la figure 3 qui illustre le flux de chaleur généré en fonction de la température en courbe 3a, la courbe 3b étant relative à la perte de masse ;
- la formation de nanoparticules d'argent à faible température de fusion aux premiers stades de la décomposition facilite le frittage;
- la maîtrise de la taille, de la morphologie et de la dispersion granulométrique des oxalates assure une homogénéité de la brasure et l'absence de fissuration.

Des conductivités thermiques pour des brasures à base d'argent, supérieure à 100 Wm$^{-1}$K$^{-1}$, peuvent typiquement être atteintes.

Le courant thermique ou flux de chaleur qui s'écoule au travers de la brasure depuis l'interface avec le composant dissipatif, vers le support encore appelé couramment la semelle, est de la forme :

$$\phi = \frac{-dQ}{dt} = \frac{-(K.A.\Delta T)}{s}$$

avec :

- -dQ/dt quantité de chaleur écoulée par unité de temps de la partie chaude vers la partie froide ;
- K: conductivité thermique de la brasure ;
- A: surface de la brasure perpendiculaire au flux de chaleur ;
- $\Delta T$: différence de température positive entre le composant dissipatif (chaud) et la semelle (froide) ;
- S : épaisseur de la brasure.

La semelle étant constituée d'un matériau massif de conductivité thermique supérieure à celle de la brasure, cette dernière limite l'écoulement de la chaleur, donc le refroidissement du composant. Il résulte de l'expression du flux, que l'épaisseur de la brasure doit être aussi faible que possible pour faciliter l'écoulement de la chaleur, c'est-à-dire que $\phi$ soit grand.

Dans la pratique, pour assembler deux pièces (composant + semelle) tout en évitant de laisser des espaces vides (sans brasure) préjudiciables à une bonne conductivité et une bonne homogénéité de température sur la surface du composant, il convient d'intercaler un matériau de brasage d'épaisseur suffisante, pour "corriger" les défauts de surface ou de planéité du composant et de la semelle. Si le matériau de brasage est simplement fondu ou fritté sans qu'il se produise une perte importante de matière, l'épaisseur de celui-ci varie peu avant et après le traitement thermique nécessaire au brasage. Seule l'élimination éventuelle de la porosité initiale peut être responsable de cette variation. Dans le cas de l'oxalate d'argent ou d'un mélange d'oxalates d'argent et de cuivre en revanche, la décomposition thermique qui se produit lors de la brasure peut être décrite par la réaction chimique suivante:

$$Ag_2C_2O_4 \rightarrow 2Ag + 2CO_2$$

$$Cu\ C_2O_4 \rightarrow Cu + 2CO_2$$

dont le bilan massique, lié à la perte de gaz carbonique, est donné par la figure 3 et notamment par la courbe 3b, la courbe 3a étant relative au flux de chaleur dégagé.

Sachant par ailleurs que les masses molaires et volumiques sont respectivement de 259,8 g.mol$^{-1}$ et 5 g.cm$^3$ pour l'oxalate d'argent et 215,8 g.mol$^{-1}$ et 10,5 g.cm$^3$ pour l'argent métallique, il apparaît que la décomposition d'un grain parfaitement dense d'oxalate, en un grain métallique lui aussi exempt de porosité, divise le volume initial par environ 2,5.

Sachant par ailleurs que les masses molaires et volumiques sont respectivement de 151,5 g.mol$^{-1}$ et 3,5 g.cm$^3$ pour l'oxalate de cuivre et 63,5 g.mol$^{-1}$ et 8,96 g.cm$^3$ pour le cuivre métallique, il apparaît que la décomposition d'un grain parfaitement dense d'oxalate, en un grain métallique lui aussi exempt de porosité, divise le volume initial par environ 6.

Dans le cas d'un oxalate d'argent ou d'un mélange d'oxalates d'argent et de cuivre, une forte diminution de l'épaisseur peut donc être attendue lors de l'opération de brasage et conduire, de manière avantageuse, à l'obtention de brasures très fines à très faible résistance thermique.

Il est à noter enfin, que les oxalates (oxalates d'argent et de cuivre en particulier) ne présentent pas de problème spécifique de toxicité. Après décomposition, on obtient une couche d'Ag pur sans risque de pollution pour l'environnement.

La demanderesse a par ailleurs comparé la température pour une puissance donnée, atteinte par un composant comprenant une brasure de l'art connu à base d'or et d'étain AuSn (ensemble de points P$_{i4}$ de la figure 4) et un composant comprenant une brasure selon l'invention provenant de la décomposition d'un oxalate (ensemble de points P$_{j4}$ de la figure 4). Il apparait ainsi que le composant à base de brasure selon l'invention, atteint une température plus basse, il est donc mieux refroidi. Le type de brasure de la présente invention permet donc une meilleure évacuation de la chaleur.

## Revendications

1. Procédé de fabrication d'une brasure destinée à relier un support et un composant dans un dispositif, **caractérisé en ce qu'**il comprend :

   - l'obtention d'un oxalate métallique par une opération de précipitation chimique d'un sel soluble métallique, par l'acide oxalique ou l'oxalate d'ammonium, dissous dans des solvants hydro-alcooliques pour obtenir ledit oxalate métallique,
   - la réalisation de l'opération de brasure en apportant le métal de brasage via l'oxalate métallique ainsi obtenu.

2. Procédé de fabrication d'une brasure destinée à relier un support et un composant dans un dispositif selon la revendication 1, **caractérisé en ce que** l'oxalate est un oxalate d'argent ou un mélange d'oxalates d'argent et de cuivre.

3. Procédé de fabrication d'une brasure destinée à relier un support et un composant dans un dispositif selon l'une des revendications 1 ou 2, **caractérisé en ce que** les solvants hydro-alcooliques possèdent des constantes diélectriques comprises entre 17 et 80.

4. Procédé de fabrication d'une brasure destinée à relier un support et un composant dans un dispositif, selon l'une des revendications 1 à 3, **caractérisé en ce que** la brasure est réalisée à partir d'une suspension contenant de l'oxalate métallique.

5. Procédé de fabrication d'une brasure destinée à relier un support et un composant dans un dispositif, selon l'une des revendications 1 à 3, **caractérisé en ce que** la brasure est réalisée à partir d'une pâte contenant de l'oxalate métallique.

6. Procédé de fabrication d'une brasure destinée à relier un support et un composant dans un dispositif, selon l'une des revendications 4 ou 5, **caractérisé en ce que** l'élaboration de ladite suspension ou de ladite pâte comprend les étapes suivantes :

   - la précipitation chimique en milieu hydro-alcoolique d'un sel soluble métallique par de l'acide oxalique ou un oxalate soluble ;
   - l'obtention d'un précipité d'oxalate présentant des caractéristiques granulométriques et morphologiques maîtrisées conduisant à des tailles de particules supérieures à environ 40 nm pour l'oxalate comprenant du cuivre et de l'argent et à environ 0,1 micron pour l'oxalate d'argent ;
- le lavage du précipité formé ;
- la mise en suspension de l'oxalate dans un milieu hydro-alcoolique à une concentration choisie, pour obtenir une suspension ou une pâte, de viscosité contrôlée.

7. Procédé de fabrication d'un dispositif comprenant un composant, et un support reliés par une brasure et comprenant le procédé de fabrication de ladite brasure selon l'une des revendications 4 ou 5, **caractérisé en ce qu'**il comprend en outre les étapes suivantes :

   - le dépôt de ladite suspension ou de ladite pâte à la surface dudit support et/ou dudit composant ;
   - l'assemblage dudit support et dudit composant via ladite suspension ou ladite pâte;
   - le chauffage de l'ensemble préconstitué.

8. Procédé de fabrication d'un dispositif selon la revendication 7, **caractérisé en ce que** le composant et/ou le support comprennent en surface un film comprenant de l'or ou du cuivre sur lequel est réalisée ladite brasure.

9. Procédé de fabrication d'un dispositif selon la revendication 8, le procédé de fabrication de ladite brasure étant selon la revendication 4, **caractérisé en ce qu'**il comprend une opération de pulvérisation de ladite suspension à base d'oxalate.

10. Procédé de fabrication d'un dispositif selon la revendication 9, le procédé de fabrication de ladite brasure étant selon la revendication 4, **caractérisé en ce qu'**il comprend une opération de dépôt de ladite suspension à base d'oxalate par jet d'encre.

11. Procédé de fabrication d'un dispositif selon la revendication 9, le procédé de fabrication de ladite brasure étant selon la revendication 5, **caractérisé en ce qu'**il comprend une opération de dépôt de la pâte à base d'oxalate, par enduction.

12. Procédé de fabrication d'un dispositif selon la revendication 9, le procédé de fabrication de ladite brasure étant selon la revendication 5, **caractérisé en ce qu'**il comprend une opération de dépôt de la pâte à base d'oxalate, par sérigraphie.

**Patentansprüche**

1. Herstellungsverfahren einer Lötung, die dazu bestimmt ist, einen Träger und eine Komponente in einer Vorrichtung zu verbinden, **dadurch gekennzeichnet, dass** es folgendes umfasst:

   - das Erlangen eines Metalloxalats durch einen Vorgang einer chemischen Präzipitation eines löslichen Metallsalzes, durch die Oxalsäure oder das Ammoniumoxalat, ausgelöst in den wässrig-alkoholischen Lösungsmitteln, um das Metalloxalat zu erlangen,
   - das Durchführen des Lötvorgangs durch Aufbringen des Lötmetalls über das Metalloxalat, das dadurch erlangt wurde.

2. Herstellungsverfahren einer Lötung, die dazu bestimmt ist, einen Träger und eine Komponente in einer Vorrichtung zu verbinden, nach Anspruch 1, **dadurch gekennzeichnet, dass** das Oxalat ein Silberoxalat oder eine Mischung aus Silber- und Kupferoxalat ist.

3. Herstellungsverfahren einer Lötung, die dazu bestimmt ist, einen Träger und eine Komponente in einer Vorrichtung zu verbinden, nach einem der Ansprüche 1 oder 2, **dadurch gekennzeichnet, dass** die wässrig-alkoholischen Lösungsmittel dielektrische Konstanten zwischen 17 und 80 besitzen.

4. Herstellungsverfahren einer Lötung, die dazu bestimmt ist, einen Träger und eine Komponente in einer Vorrichtung zu verbinden, nach einem der Ansprüche 1 bis 3, **dadurch gekennzeichnet, dass** die Lötung anhand einer Suspension durchgeführt wird, die das Metalloxalat enthält.

5. Herstellungsverfahren einer Lötung, die dazu bestimmt ist, einen Träger und eine Komponente in einer Vorrichtung zu verbinden, nach einem der Ansprüche 1 bis 3, **dadurch gekennzeichnet, dass** die Lötung anhand einer Paste durchgeführt wird, die das Metalloxalat enthält.

**6.** Herstellungsverfahren einer Lötung, die dazu bestimmt ist, einen Träger und eine Komponente in einer Vorrichtung zu verbinden, nach einem der Ansprüche 4 oder 5, **dadurch gekennzeichnet, dass** die Zubereitung der Suspension oder der Paste die folgenden Schritte umfasst:

- die chemische Präzipitation in wässrig-alkoholischer Umgebung eines löslichen Metallsalzes durch die Oxalsäure oder ein lösliches Oxalat;
- das erlangen eines Oxalat-Präzipitats, das kontrollierte granulometrische und morphologische Eigenschaften aufweist, die zu Partikelgrößen über ca. 40 nm für das Oxalat, das Kupfer und Silber umfasst, und ca. 0,1 Mikrometer für das Silberoxalat führen;
- das Waschen des gebildeten Präzipitats;
- das Bringen in Suspension des Oxalats in einer wässrig-alkoholischen Umgebung mit einer gewählten Konzentration, um eine Suspension oder eine Paste mit kontrollierter Viskosität zu erlangen.

**7.** Herstellungsverfahren einer Vorrichtung, die eine Komponente und einen Träger umfasst, verbunden durch eine Lötung und umfassend das Herstellungsverfahren der Lötung nach einem der Ansprüche 4 oder 5, **dadurch gekennzeichnet, dass** es unter anderem die folgenden Schritte umfasst:

- das Aufbringen der Suspension oder der Paste auf die Oberfläche des Trägers und/oder der Komponente;
- das Zusammensetzen des Trägers und der Komponente mittels der Suspension oder der Paste;
- das Erhitzen der vorgebildeten Einheit.

**8.** Herstellungsverfahren einer Vorrichtung nach Anspruch 7, **dadurch gekennzeichnet, dass** die Komponente und/oder der Träger an der Oberfläche einen Film umfassen, der Gold oder Kupfer umfasst, aus dem die Lötung durchgeführt wird.

**9.** Herstellungsverfahren einer Vorrichtung nach Anspruch 8, wobei das Herstellungsverfahren der Lötung nach Anspruch 4 ist, **dadurch gekennzeichnet, dass** es einen Pulverisierungsvorgang der Suspension auf Oxalatbasis umfasst.

**10.** Herstellungsverfahren einer Vorrichtung nach Anspruch 9, wobei das Herstellungsverfahren der Lötung nach Anspruch 4 ist, **dadurch gekennzeichnet, dass** es einen Aufbringungsvorgang der Suspension auf Oxalatbasis durch Tintenstrahl umfasst.

**11.** Herstellungsverfahren einer Vorrichtung nach Anspruch 9, wobei das Herstellungsverfahren der Lötung nach Anspruch 5 ist, **dadurch gekennzeichnet, dass** es einen Aufbringungsvorgang der Paste auf Oxalatbasis durch Beschichtung umfasst.

**12.** Herstellungsverfahren einer Vorrichtung nach Anspruch 9, wobei das Herstellungsverfahren der Lötung nach Anspruch 5 ist, **dadurch gekennzeichnet, dass** es einen Aufbringungsvorgang der Paste auf Oxalatbasis durch Siebdruck umfasst.

**Claims**

**1.** Process for producing a braze which is intended to connect a support and a component in a device, **characterised in that** it comprises:

- obtaining a metal oxalate via a chemical precipitation operation of a soluble metal salt, using oxalic acid or ammonium oxalate, dissolved in hydroalcoholic solvents in order to obtain the metal oxalate,
- carrying out the brazing operation by providing the brazing metal via the metal oxalate obtained in this manner.

**2.** Process for producing a braze which is intended to connect a support and a component in a device according to claim 1, **characterised in that** the oxalate is a silver oxalate or an admixture of silver and copper oxalates.

**3.** Process for producing a braze which is intended to connect a support and a component in a device according to either claim 1 or claim 2, **characterised in that** the hydroalcoholic solvents have dielectric constants between 17 and 80.

4. Process for producing a braze which is intended to connect a support and a component in a device according to any one of claims 1 to 3, **characterised in that** the braze is produced from a suspension containing metal oxalate.

5. Process for producing a braze which is intended to connect a support and a component in a device according to any one of claims 1 to 3, **characterised in that** the braze is produced from a paste containing metal oxalate.

6. Process for producing a braze which is intended to connect a support and a component in a device according to either claim 4 or claim 5, **characterised in that** the production of the suspension or the paste comprises the following steps:

- the chemical precipitation, in a hydroalcoholic medium, of a soluble metal salt by oxalic acid or a soluble oxalate;
- obtaining an oxalate precipitate having controlled particle size and morphological characteristics resulting in particle sizes greater than approximately 40 nm for the oxalate comprising copper and silver and approximately 0.1 micrometre for the silver oxalate;
- washing the precipitate formed;
- putting the oxalate into suspension in a hydroalcoholic medium at a chosen concentration in order to obtain a suspension or a paste of controlled viscosity.

7. Process for producing a device comprising a component and a support which are connected by a braze and comprising the process for producing the braze according to either claim 4 or 5, **characterised in that** it further comprises the following steps:

- the deposition of the suspension or the paste on the surface of the support and/or the component;
- the assembling of the support and of the component via the suspension or the paste;
- the heating of the preconstituted assembly.

8. Process for producing a device according to claim 7, **characterised in that** the component and/or the support comprise at the surface a film comprising gold or copper on which the braze is produced.

9. Process for producing a device according to claim 8, the process for producing the braze being in accordance with claim 4, **characterised in that** it comprises an operation for spraying the oxalate-based suspension.

10. Process for producing a device according to claim 9, the process for producing the braze being in accordance with claim 4, **characterised in that** it comprises an operation for depositing the oxalate-based suspension by means of inkjet.

11. Process for producing a device according to claim 9, the process for producing the braze being in accordance with claim 5, **characterised in that** it comprises an operation for depositing the oxalate-based paste by means of coating.

12. Process for producing a device according to claim 9, the process for producing the braze being in accordance with claim 5, **characterised in that** it comprises an operation for depositing the oxalate-based paste by means of screen printing.

FIG.1

FIG.2

FIG.3

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 294880 A
- EP 0254935 A